# FASCICULE DE BREVET EUROPEEN

(11) **EP 3 127 159 B1**
(45) Date de publication et mention de la délivrance du brevet: **24.04.2019**
(21) Numéro de dépôt: 15741856.7
(22) Date de dépôt: 27.03.2015
(51) Int. Cl.: H01L 27/15, H01L 33/50

(54) **PIXEL SEMICONDUCTEUR, MATRICE DE TELS PIXELS, STRUCTURE SEMICONDUCTRICE POUR LA RÉALISATION DE TELS PIXELS ET LEURS PROCÉDÉS DE FABRICATION**
HALBLEITENDES PIXEL, MATRIX AUS SOLCHEN PIXELN, HALBLEITENDE STRUKTUR ZUR HERSTELLUNG SOLCHER PIXEL UND DEREN HERSTELLUNGSVERFAHREN
SEMICONDUCTING PIXEL, MATRIX OF SUCH PIXELS, SEMICONDUCTING STRUCTURE FOR THE PRODUCTION OF SUCH PIXELS AND THEIR METHODS OF FABRICATION

(30) Priorité: 01.04.2014 FR 1452876
(43) Date de publication de la demande: 08.02.2017
(73) Titulaire: Centre National de la Recherche Scientifique, 75016 Paris (FR)
(72) Inventeur: DAMILANO, Benjamin, F-06200 Nice (FR); DUBOZ, Jean-Yves, F-06560 Valbonne (FR)
(74) Mandataire: Priori, Enrico
(86) Numéro de dépôt international: PCT/EP2015/056779
(87) Numéro de publication internationale: WO 2015/150281

(56) Documents cités:
- EP-A2- 2 187 442
- WO-A1-2010/123814
- US-A1- 2009 001 389
- US-A1- 2011 233 575
- US-A1- 2011 256 648

## Description

L'invention porte sur un pixel semi-conducteur, en particulier à base de semi-conducteurs inorganiques et plus particulièrement à base de (Al,Ga,In)N, ainsi que sur une matrice de tels pixels. L'invention porte également sur des structures semi-conductrices servant de base à la réalisation de tels pixels, et sur des procédés de fabrication de ces derniers.

L'invention s'applique en particulier à la réalisation d'écrans couleurs miniaturisés et de projecteurs « près de l'oeil », ainsi qu'à l'éclairage.

Il est connu de réaliser des dispositifs émetteurs de lumière dont la couleur est obtenue et contrôlée en mélangeant des teintes primaires. La combinaison de trois diodes électroluminescentes (DELs) émettant chacune à une longueur d'onde spécifique correspondant au bleu, au vert et au rouge permet d'obtenir n'importe quelle couleur pourvu que le rapport d'intensité entre chaque DEL soit bien contrôlé. Cette propriété est particulièrement intéressante pour fabriquer des écrans ou des lampes avec des teintes et des intensités variables (« éclairage intelligent »). Pour ce type d'applications, on peut assembler trois DELs distinctes, qui peuvent si nécessaire être fabriquées à partir de matériaux semi-conducteurs distincts. La configuration la plus courante est par exemple d'utiliser deux DELs à base de nitrures (AlInGaN) pour le bleu et le vert, et une DEL phosphure (AlGaInP) pour le rouge. L'utilisation de trois DELs différentes a cependant un surcoût non négligeable par rapport à une seule DEL. D'autre part, combiner trois DELs distincts pour la réalisation de chaque pixel pose des problèmes de miniaturisation qui deviennent insolubles pour des applications de type écran avec une taille de pixel faible.

Ces problèmes de miniaturisation peuvent être résolus par l'utilisation de DEL organiques (« OLEDs »), qui permettent d'associer aisément trois ou quatre émetteurs de couleurs différentes dans chaque pixel d'un écran à matrice active. Toutefois la luminance des OLEDs est trop faible pour certaines applications, telles que l'éclairage ou la projection « près de l'oeil ».

Il a également été proposé de réaliser un empilement de couches semi-conductrices inorganiques comportant trois DELs ou plus, émettant à des longueurs d'onde différentes, pouvant être contrôlées indépendamment les unes des autres. De cette façon, un seul empilement constitue un pixel complet, dans lequel les différents sous-pixels sont superposés au lieu d'être agencés les uns à côté des autres. Voir à ce propos US 8,058,663. Une telle structure est difficile à réaliser, et surtout à hybrider, car il faut interconnecter de manière indépendante plusieurs couches actives situées à des profondeurs différentes de l'empilement. Par ailleurs, les structures décrites par le document US 8,058,663 comportent soit une pluralité de jonctions tunnel destinées à être connectées en série, soit des contacts pris sur des « marches d'escalier » gravées dans des couches semi-conductrices présentant un dopage de type p ; dans les deux cas, on obtient des résistances électriques relativement importantes, induisant des pertes élevées. En outre, les profondeurs à graver sont relativement importantes, ce qui pose des limites à la miniaturisation atteignable.

Les documents US 2011/233575 et EP 2 187 442 utilisent des luminophores pour effectuer des conversions de longueur d'onde, permettant ainsi d'obtenir différentes couleurs à partir d'une même structure électroluminescente. Cependant l'épaisseur des couches de luminophore doit être suffisamment grande (de l'ordre de la centaine de µm) de manière à pourvoir absorber la lumière émise par la couche active injectée électriquement. Une telle épaisseur n'est pas compatible avec une miniaturisation poussée des pixels (dimensions latérales de l'ordre de la dizaine de µm) en raison d'absorption de lumière croisée entre les différents pixels.

Les documents WO 2010/123814 et US 2011/0256648 enseignent l'utilisation de convertisseurs de longueur d'onde semi-conducteurs dans le même but. Les structures décrites dans ces documents ne peuvent pas être considérées comme monolithiques ; leur fabrication nécessite des étapes de collage qui sont complexes à réaliser.

L'invention vise à surmonter au moins certains des inconvénients précités de l'art antérieur. Plus précisément elle vise à procurer :
- une structure de pixel semi-conducteur pouvant être réalisée à partir de semi-conducteurs inorganiques (donc, potentiellement, à haute luminosité), de façon simple et pouvant être miniaturisée, par exemple jusqu'à une taille latérale inférieure ou égale à 10 µm ;
- une matrice de tels pixels, pouvant être utilisée dans un écran, un projecteur ou un dispositif d'éclairage ;
- des structures semi-conductrices monolithiques pouvant être utilisées pour réaliser un tel pixel ou matrice de pixels ; et
- des procédés de fabrication de tels pixels ou matrices de pixels.

Conformément à l'invention, ces objectifs sont atteints grâce à une structure de pixel comprenant trois sous-pixels adjacents, réalisés par gravure à partir d'une même structure comprenant trois couches actives (émettrices de lumière) - ou seulement deux couches, une troisième étant rapportée ultérieurement. Au moins une, et de préférence deux, de ces couches actives sont pompées électriquement, la ou les couche(s) restante(s) étant pompée(s) optiquement pour fonctionner en tant que convertisseur(s) de longueur d'onde. Une telle structure de pixel peut être réalisée à base de semi-conducteurs inorganiques et présenter donc une luminosité bien plus élevée de celle atteignable par des OLEDs. Par rapport aux dispositif décrits dans le document US 8,058,663, l'hybridation est beaucoup plus simple et les pertes peuvent être moindres (une seule jonction tunnel est nécessaire pour permettre d'arrêter toutes les gravures sur des couches dopées n). Par ailleurs, comme la structure est gravée sur ses deux faces, la profondeur de gravure est réduite, ce qui permet une miniaturisation très poussée des sous-pixels.

Un objet de l'invention est donc un pixel comprenant au moins trois sous-pixels disposés l'un à côté de l'autre, chaque dit sous-pixel comprenant un empilement respectif de couches semi-conductrices, dans lequel :
- chaque dit sous-pixel comprend une première couche active, adaptée pour émettre une lumière à une première longueur d'onde lorsqu'elle est traversée par un courant électrique ;
- au moins un dit sous pixel, dit premier sous pixel, comprend également une première et une deuxième électrode agencées de part et d'autre de ladite première couche active pour permettre à un courant électrique de la traverser ;
- un autre desdits sous-pixels, dit deuxième sous-pixel, comprend également une deuxième couche active, adaptée pour émettre une lumière à une deuxième longueur d'onde supérieure à ladite première longueur d'onde ;
- un autre desdits sous-pixels, dit troisième sous-pixel, comprend également une troisième couche active, adaptée pour émettre une lumière à une troisième longueur d'onde supérieure à ladite première longueur d'onde et différente de ladite deuxième longueur d'onde ;
au moins une parmi lesdites deuxième et troisième couche active étant adaptée pour émettre ladite lumière lorsqu'elle est excitée par la lumière à la première longueur d'onde émise par ladite première couche active du même sous-pixel, ledit pixel étant caractérisé en ce que :
ladite première couche active est au moins partiellement transparente à ladite deuxième longueur d'onde ; ladite deuxième couche active dudit deuxième sous pixel est agencée d'un premier coté de ladite première couche active et adaptée pour émettre ladite lumière à ladite deuxième longueur d'onde lorsqu'elle est parcourue par un courant électrique, ledit deuxième sous-pixel comprenant également une troisième et une quatrième électrode agencées de part et d'autre de ladite deuxième couche active pour permettre à un courant électrique de la traverser sans traverser ladite première couche active ; et ladite troisième couche active dudit troisième sous pixel est agencée d'un deuxième coté de ladite première couche active, opposé audit premier coté, et adaptée pour émettre ladite lumière à ladite troisième longueur d'onde lorsqu'elle est excitée par la lumière à la première longueur d'onde émise par ladite première couche active dudit troisième sous-pixel, ledit troisième sous-pixel comprenant également une cinquième et une sixième électrode agencées de part et d'autre de ladite première couche active pour permettre à un courant électrique de la traverser.

Selon différents modes de réalisation d'un tel pixel :
- Ladite première longueur d'onde peut appartenir à la partie bleue du spectre visible, ladite deuxième longueur d'onde à sa partie rouge et ladite troisième longueur d'onde à sa partie verte.
- En variante, ladite première longueur d'onde peut appartenir à la partie bleue du spectre visible, ladite deuxième longueur d'onde à sa partie verte et ladite troisième longueur d'onde à sa partie rouge.
- Un tel pixel peut présenter une structure monolithique.

Altemativement, il peut présenter une structure monolithique à l'exception de ladite troisième couche active, qui est alors rapportée.
- Lesdites couches actives peuvent être réalisées à base de (Al,Ga,In)N.
- Lesdites premières couches actives desdits sous-pixels peuvent être coplanaires, de même composition et de même structure.

Un autre objet de l'invention est une matrice de pixels comprenant une pluralité de tels pixels hybridés sur un substrat hôte portant un circuit de contrôle desdits sous-pixels, lesdites première et troisième couche active étant respectivement la couche active la plus proche et la plus éloignée dudit substrat hôte.

Encore un autre objet de l'invention est une structure semi-conductrice comprenant un empilement de couches épitaxiales semi-conductrices déposées sur un substrat, ledit empilement comprenant, à partir dudit substrat : un premier sous-ensemble de couches semi-conductrices comprenant au moins une couche photoluminescente, dite troisième couche active, adaptée pour émettre une lumière à une longueur d'onde dite troisième longueur d'onde, lesdites couches présentant un dopage d'un même type ; un deuxième sous-ensemble de couches semi-conductrices formant une diode électroluminescente comprenant une couche électroluminescente, dite première couche active, adaptée pour émettre une lumière à une longueur d'onde dite première longueur d'onde ; et un troisième sous-ensemble de couches semi-conductrices formant une diode électroluminescente comprenant une couche électroluminescente, dite deuxième couche active, adaptée pour émettre une lumière à une longueur d'onde dite deuxième longueur d'onde ; lesdites première, deuxième et troisième longueur d'onde étant différentes entre elles et ladite première longueur d'onde étant inférieure auxdites deuxième et troisième longueurs d'onde.

Avantageusement, dans une telle structure ledit premier sous-ensemble de couches semi-conductrices peut présenter un dopage de type n et dans laquelle une jonction tunnel est interposée entre ledit deuxième sous-ensemble et ledit troisième sous-ensemble de couches semi-conductrices.

Encore un autre objet de l'invention est un procédé de fabrication d'un pixel comportant les étapes suivantes :
a) procurer une structure semi-conductrice telle que mentionnée ci-dessus ;
b) graver ladite structure pour définir un premier, un deuxième et un troisième plots destinés à former des sous-pixels respectifs, au moyen d'une gravure s'étendant au moins à travers lesdites première et deuxième couches actives ;
c) graver ledit premier plot et ledit troisième plot, mais pas ledit deuxième plot, pour en retirer ladite deuxième couche active ;
d) réaliser une paire de contacts électriques situés de part et d'autre de ladite deuxième couche active dudit deuxième plot, et deux paires de contacts électriques situés de part et d'autre de ladite première couche active desdits premier et troisième plots ;
e) retirer ledit substrat ; et
f) graver la structure pour retirer ladite troisième couche active en correspondance desdits premier et deuxième plot, mais pas dudit troisième plot.

Encore un autre objet de l'invention est un procédé de fabrication d'un pixel comportant les étapes suivantes :
a') procurer une structure semi-conductrice comprenant : un premier sous-ensemble de couches semi-conductrices formant une diode électroluminescente comprenant une couche électroluminescente, dite première couche active, adaptée pour émettre une lumière à une longueur d'onde dite première longueur d'onde ; et un deuxième sous-ensemble de couches semi-conductrices formant une diode électroluminescente comprenant une couche électroluminescente, dite deuxième couche active (52'), adaptée pour émettre une lumière à une longueur d'onde dite deuxième longueur d'onde, supérieure à ladite première longueur d'onde ;
b) graver ladite structure pour définir un premier, un deuxième et un troisième plots destinés à former des sous-pixels respectifs, au moyen d'une gravure s'étendant à travers lesdites première et deuxième couches actives ;
c) graver ledit premier plot et ledit troisième plot, mais pas ledit deuxième plot, pour en retirer ladite deuxième couche active ;
d) réaliser une paire de contacts électriques situés de part et d'autre de ladite deuxième couche active dudit troisième, et deux paires de contacts électriques situés de part et d'autre de ladite première couche active desdits premier et deuxième plots ;
e) retirer ledit substrat ; et
f) soit rapporter, à la place dudit substrat, une couche photoluminescente dite troisième couche active adaptée pour émettre une lumière à une troisième longueur d'onde lorsqu'elle est excitée par une lumière à ladite première longueur d'onde, puis retirer par gravure ladite troisième couche active en correspondance dudit premier et deuxième plots ; soit rapporter ladite troisième couche active en correspondance dudit troisième plot et à l'exclusion dudit premier et deuxième plots.

D'une manière générale on entend par :
- « lumière » ou « rayonnement lumineux » un rayonnement électromagnétique de longueur d'onde comprise entre 380 et 780 nm.
- « lumière bleue » ou « rayonnement bleu » un rayonnement électromagnétique de longueur d'onde comprise entre 380 et 490 nm, et de préférence entre 430 nm et 470 nm ;
- « lumière verte » ou « rayonnement vert » un rayonnement électromagnétique de longueur d'onde comprise entre 500 nm et 560 nm, et de préférence entre 510 nm et 530 nm ;
- « lumière rouge » ou « rayonnement rouge » un rayonnement électromagnétique de longueur d'onde comprise entre 600 et 780 nm, et de préférence entre 610 nm et 640 nm ;
- « couche partiellement transparente » une couche présentant une transmittance supérieure ou égale à 25%, plus avantageusement supérieure ou égale à 50%, de préférence supérieure ou égale à 75%, de manière encore préférée supérieure ou égale à 90%, voire à 95%.

D'autres caractéristiques, détails et avantages de l'invention ressortiront à la lecture de la description faite en référence aux dessins annexés donnés à titre d'exemple et qui représentent, respectivement :
- Les figures 1A - 1E, les différentes étapes d'un procédé de fabrication d'un pixel semi-conducteur selon un premier mode de réalisation de l'invention ;
- Les figures 2A - 2E, les différentes étapes d'un procédé de fabrication d'un pixel semi-conducteur selon un deuxième mode de réalisation de l'invention ;
- La figure 3, une vue latérale d'une matrice de pixels semi-conducteurs selon ledit premier mode de réalisation.

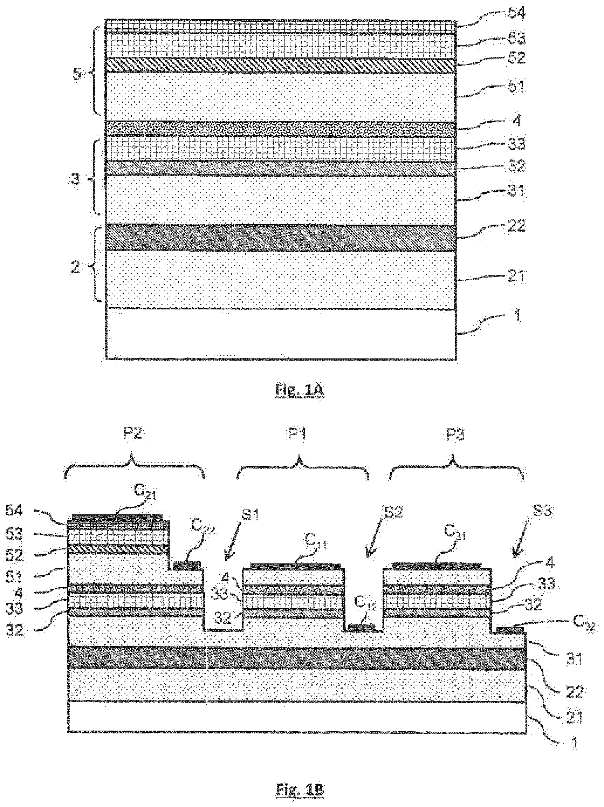

La figure 1A montre une structure monolithique épitaxiale pouvant être utilisée comme point de départ pour un procédé de fabrication d'un pixel semi-conducteur selon un premier mode de réalisation de l'invention. Cette structure comprend, à partir du bas :
- Un substrat 1, par exemple en saphir ; ce substrat sera éliminé au cours du procédé de fabrication, par conséquent sa nature n'a que peu d'importance, pourvu qu'elle permette la croissance épitaxiale des autres couches constituant la structure. Ainsi à la place du saphir on pourrait utiliser, par exemple, un substrat en Si, SiC ou ZnO.
- Un premier sous-ensemble de couches semi-conductrices 2 comprenant, dans l'ordre, une couche 21 en GaN dopé de type n, par exemple d'épaisseur égale à 2 µm, ayant uniquement une fonction de conduction électrique, et une couche « active » (c'est-à-dire émettrice de lumière) 22 comprenant un empilement de puits quantiques (Ga,ln)N/(Al,Ga,In)N, présentant également un dopage de type n ou non intentionnellement dopé et susceptible d'émettre un rayonnement lumineux vert lorsqu'elle est excitée par un rayonnement lumineux bleu. La couche active peut comprendre, par exemple, 50 périodes In_{0,25}Ga_{0,75}N (2 nm) / GaN (10 nm).
- Un deuxième sous-ensemble de couches semi-conductrices 3 formant une diode électroluminescente et comprenant une couche 31 en GaN dopé n (par exemple d'épaisseur égale à 1 µm), une couche « active » 32 comprenant un empilement de puits quantiques (Ga,In)N/(Al,Ga,In)N dopé n ou non intentionnellement dopé (par exemple comprenant 5 périodes In_{0,15}Ga_{0,85}N (2 nm) / GaN (10 nm),) susceptible d'émettre un rayonnement bleu lorsqu'elle est pompée électriquement et une autre couche 33 en GaN dopé p (par exemple, d'épaisseur égale à 200 nm), de manière à former une jonction p-n.
- Une jonction tunnel 4 (p++/n++, par exemple d'épaisseur égale à 50 nm).
- Un troisième sous-ensemble de couches semi-conductrices 5 formant une diode électroluminescente et comprenant une couche 51 en GaN dopé n (1 µm), une couche « active » 52 comprenant un empilement de puits quantiques (Ga,In)N/(Al,Ga,In)N dopé n ou non intentionnellement dopé (par exemple, 5 périodes In_{0,40}Ga_{0.60}N (2 nm) / GaN (10 nm),) susceptible d'émettre un rayonnement rouge lorsqu'elle est pompée électriquement, une autre couche 53 en GaN dopé p (200 nm), de manière à former une jonction p-n et une couche de contact 54 dopée p++ (20 nm). On remarquera que la jonction tunnel 4 permet d'éviter que les couches 33 et 51 forment une jonction p-n parasite qui serait polarisée inversement lorsque les diodes 3 et 5 sont polarisées directement. En principe, on pourrait modifier la structure pour ne pas utiliser une jonction tunnel, mais cela obligerait à arrêter des étapes de gravure sur des couches dopées p, ce qui n'est pas souhaitable pour des raisons technologiques.

Comme cela sera expliqué plus loin, les couches 31 et 51 serviront de couches d'arrêt de gravure ; elles seront donc, en général, plus épaisses que les autres couches de la structure.

En principe, on pourrait inverser le dopage de toutes les couches de la figure 1A, mais cela ne serait pas avantageux car le GaN dopé p est sensiblement plus résistif que le GaN dopé n.

Conformément à l'invention, la structure de la figure 1A est ensuite traitée par des étapes classiques de photolithographies et d'évaporation de métaux, comme cela sera expliqué en détail à l'aide des figures 1B - 1E.

La figure 1B montre la structure après :
- Une première étape de gravure définissant trois plots P1, P2 et P3, destinés à former des sous-pixels respectifs, séparés par deux sillons S1 et S2 qui s'étendent, en profondeur, jusqu'à la couche 31 ; un troisième sillon S3 de même profondeur est gravé sur le côté du plot P3. Il est important que ces sillons traversent au moins les couches actives 32 et 52, mais pas l'intégralité de la structure jusqu'au substrat.
- Une deuxième étape de gravure, retirant les couches 52, 53, 54, et une partie de la couche 51, des plots P1 et P3, et réalisant une « marche d'escalier » au niveau de la couche 52 du plot P2.
- Une étape de dépôt métallique réalisant des contacts électriques au sommet des plots P1, P2 et P3, au fond des sillons S2 et S3 et sur la « marche d'escalier » précitée. Ces contacts électriques sont identifiés parles références C₁₁, C₁₂, C₂₁, C₂₂, C₃₁, C₃₂.

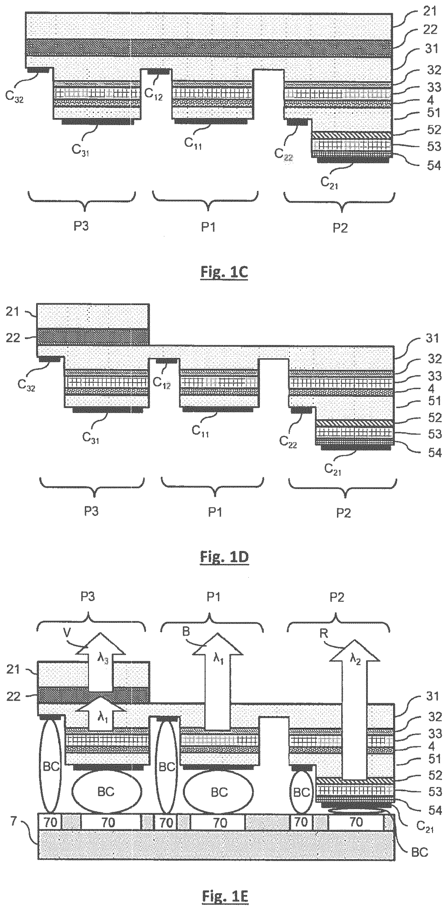

Ensuite, la structure est retournée et le substrat retiré (figure 1C).

Suit une étape de gravure « face arrière », qui retire la couche 21 et la couche active « verte » 22 des plots P1 et P2, mais pas du plot P3 (figure 1D).

L'ordre dans lequel certaines étapes sont mises en oeuvre peut être modifié. Par exemple, les contacts électriques peuvent être déposés avant ou après l'enlèvement du substrat et la gravure de la couche active verte.

La structure de pixel P ainsi obtenue est hybridée sur un substrat 7 portant un circuit de commande du pixel au moyen de billes de contact BC, généralement en indium (figure 1E). Le substrat 7 peut être constitué par un circuit imprimé, voire un circuit intégré ; la référence 70 identifie des pistes conductrices du circuit de commande.

Les contacts C₁₁, C₁₂ forment des électrodes permettant de polariser directement la diode électroluminescente bleue 3 du plot P1, qui forme ainsi un sous-pixel « bleu », émettant une lumière B à une première longueur d'onde λ₁.

Les contacts C₂₁, C₂₂ forment des électrodes permettant de polariser directement la diode électroluminescente rouge 5 du plot P2, qui forme ainsi un sous-pixel « rouge » émettant une lumière R à une deuxième longueur d'onde λ₂>λ₁. Il convient de noter que l'ensemble de l'empilement de couches semi-conductrices situé au-dessus de la couche active 52 est transparent à la lumière rouge.

Les contacts C₃₁, C₃₂ forment des électrodes permettant de polariser directement la diode électroluminescente bleue 3 du plot P3 ; la lumière bleue émise par la couche active 32 pompe optiquement la couche active 22, qui réémet une lumière verte V, à une troisième longueur d'onde λ₃>λ₁. Le plot P3 forme ainsi un sous-pixel « vert ».

Les trois sous-pixels peuvent donc être pilotés de manière indépendante, pour former un pixel de type « rouge-vert-bleu » (RVB). D'une manière connue, il est possible de réaliser des pixels comprenant plus de trois sous-pixels. Ces derniers peuvent présenter toute forme et tout agencement connu dans la technique.

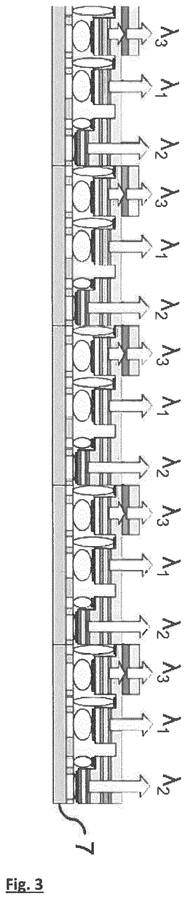

Le procédé a été décrit en référence à la fabrication d'un seul pixel isolé, mais il se généralise aisément à la fabrication d'une matrice de pixels, éventuellement monolithique, pouvant servir à la réalisation d'un écran d'affichage. La figure 3 montre une vue latérale d'une telle matrice.

Bien que le terme « pixel » suggère une application d'affichage, un dispositif optoélectronique du type illustré sur la figure 1E peut également servir en tant qu'élément d'éclairage à couleur variable dont la surface active peut être de l'ordre du mm², typique des DELs blanches inorganiques.

La structure de la figure 1A présente, à partir du substrat, une couche active 22 « verte » (émettant une lumière verte), une couche active 32 « bleue » et une couche active 52 « rouge ». En principe on pourrait envisager d'inverser les positions des couches actives verte et bleue, mais cela conduirait à pomper un émetteur rouge avec une lumière verte, ce qui ne peut pas être réalisé de façon efficace, en tout cas pas avec des matériaux de la famille (Al,Ga,In)N du fait de la faible absorption de la lumière verte par des puits quantiques (Ga,In)N/(Al,Ga,In)N émettant dans le rouge .

Il est également possible d'inverser les positions des couches actives rouge et verte. Toutefois, dans ce cas il n'est pas conseillé de réaliser une structure monolithique à base de (Ga,In)N/(Al,Ga,In)N. En effet il est connu que les émetteurs rouges en (Ga,In)N/(Al,Ga,In)N sont très sensibles à la température. En déposant un tel émetteur avant les couches actives bleue et verte, on risquerait de l'endommager. Par conséquent, il est préférable d'utiliser un convertisseur de longueur d'onde rapporté, émettant dans le rouge. Pour pouvoir miniaturiser le pixel il est préférable d'utiliser, en tant que convertisseur, un semi-conducteur tel que l'(Al,Ga,In)P plutôt qu'un phosphore, qui devrait être relativement épais (de l'ordre de 100 µm pour assurer une bonne absorption de la lumière d'excitation).

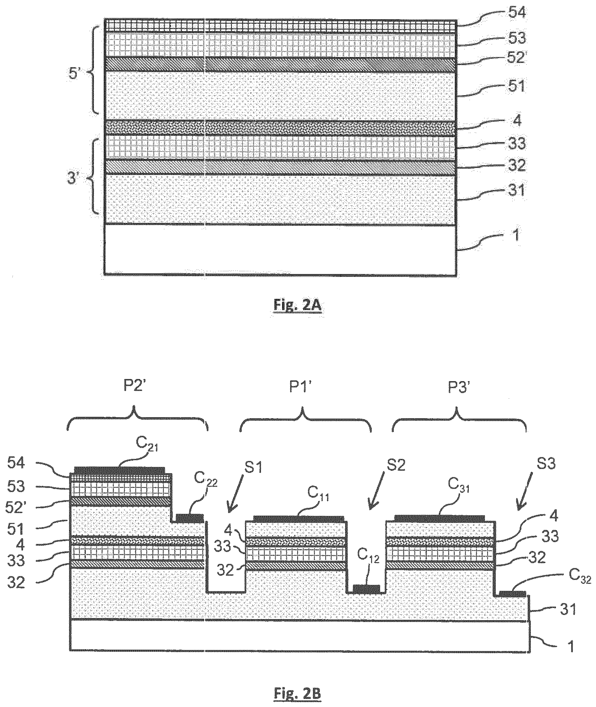

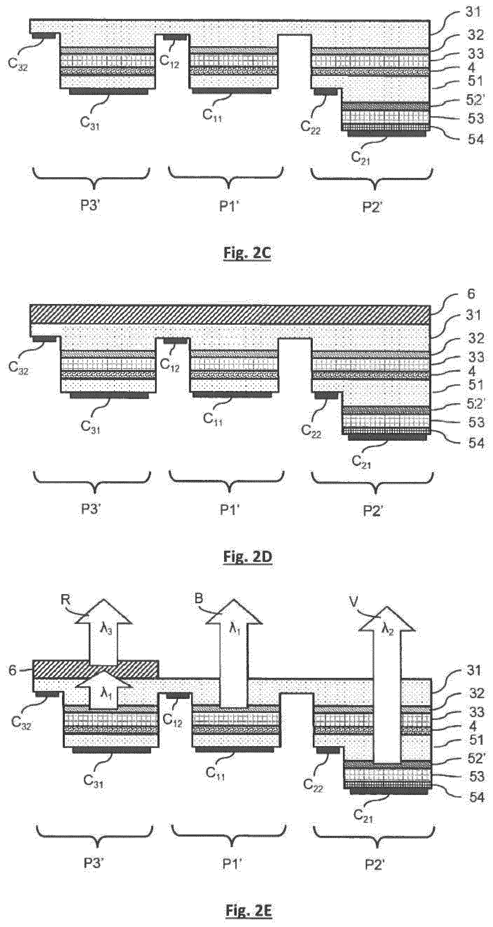

Les figures 2A - 2E illustrent la fabrication d'un pixel selon un deuxième mode de réalisation de l'invention, comportant un convertisseur de longueur d'onde rapporté, émettant dans le rouge.

Le point de départ d'un tel procédé (figure 2A) est une structure semblable à celle de la figure 1A mais ne comportant pas les couches 21 et 22 ; dans cette structure, la couche 31 est directement déposée sur le substrat. En outre, la couche active la plus éloignée du substrat (référence 52') est adaptée pour émettre un rayonnement vert, au lieu d'un rayonnement rouge comme la couche active 52 des figures 1A - 1E. Sur la figure 2A, la référence 3' identifie un premier empilement de couches semi-conductrices, comprenant les couches 31, 32 et 33, et sensiblement identique au deuxième empilement 3 de la figure 1A ; la référence 5' identifie un deuxième empilement de couches semi-conductrices comprenant les couches 51, 52', 53 et 54.

Les premières étapes de gravure (figure 2B), retournement et élimination du substrat (figure 2C) sont sensiblement identiques aux étapes correspondantes du procédé décrit plus haut ; les trois plots sont identifiés par les références P1', P2' et P3' pour les distinguer de ceux du premier mode de réalisation. Ensuite, comme illustré sur la figure 2D, le procédé comprend une étape consistant à rapporter (par exemple par collage) un convertisseur de longueur d'onde émettant dans le rouge (référence 6) - par exemple à base d'(Al,Ga,In)P - et une étape de gravure pour éliminer ce convertisseur sauf en correspondance du troisième plot P3'. En variante, on pourrait rapporter le convertisseur 6 seulement en correspondance dudit troisième plot, mais en pratique cela serait très difficile.

L'étape d'hybridation sur un substrat portant un circuit de contrôle, non représentée, se fait comme dans le cas du premier mode de réalisation.

L'ordre dans lequel certaines étapes sont mises en oeuvre peut être modifié. Par exemple, les contacts électriques peuvent être déposés avant ou après l'enlèvement du substrat et le collage du convertisseur de longueur d'onde.

Un convertisseur de longueur d'onde rapporté (vert, dans ce cas) pourrait également être utilisé dans le mode de réalisation de la figure 1E. Dans ce cas, le convertisseur pourrait avantageusement être réalisé en semi-conducteur de type II-VI.

L'invention a été décrite en référence à un certain nombre de modes de réalisation, utilisant essentiellement des matériaux de la famille (Al,Ga,In)N ; toutefois, l'utilisation d'autres matériaux semi-conducteurs, notamment inorganiques, peut être envisagée sans sortir du domaine de l'invention. L'utilisation, dans les couches actives, de structures à confinement quantique (puits ou boîtes quantiques) est avantageuse mais pas essentielle. Par ailleurs, en fonction de l'application visée, un dispositif selon l'invention peut comprendre plus de trois couches actives. En outre, surtout dans des applications autres que l'affichage (éclairage, par exemple), lesdites couches actives peuvent émettre des rayonnements de couleurs autres que le rouge, le vert et le bleu.

Les valeurs et compositions indiquées ci-dessus sont données uniquement à titre d'exemples non limitatifs.

## Revendications

1. Pixel comprenant au moins trois sous-pixels (P1, P2, P3 ; P1', P2', P3' ; P1", P2", P3") disposés l'un à côté de l'autre, chaque dit sous-pixel comprenant un empilement respectif de couches semi-conductrices, dans lequel :
- chaque dit sous-pixel comprend une première couche active (32, 360), adaptée pour émettre une lumière à une première longueur d'onde (λ₁) lorsqu'elle est traversée par un courant électrique ;
- au moins un dit sous pixel, dit premier sous pixel (P1, P1', P1"), comprend également une première (C₁₁) et une deuxième (C₁₂) électrode agencées de part et d'autre de ladite première couche active pour permettre à un courant électrique de la traverser ;
- un autre desdits sous-pixels, dit deuxième sous-pixel (P2, P2', P2"), comprend également une deuxième couche active (52, 52'), adaptée pour émettre une lumière à une deuxième longueur d'onde (λ₂) supérieure à ladite première longueur d'onde ;
- un autre desdits sous-pixels, dit troisième sous-pixel (P3, P3', P3"), comprend également une troisième couche active (22, 6, 320), adaptée pour émettre une lumière à une troisième longueur d'onde (λ₃) supérieure à ladite première longueur d'onde et différente de ladite deuxième longueur d'onde ;
au moins une parmi lesdites deuxième et troisième couche active étant adaptée pour émettre ladite lumière lorsqu'elle est excitée par la lumière à la première longueur d'onde émise par ladite première couche active du même sous-pixel
ledit pixel étant **caractérisé en ce que** :
- ladite première couche active (32) est au moins partiellement transparente à ladite deuxième longueur d'onde (λ₂) ;
- ladite deuxième couche active (52, 52') dudit deuxième sous pixel est agencée d'un premier coté de ladite première couche active et adaptée pour émettre ladite lumière à ladite deuxième longueur d'onde (λ₂) lorsqu'elle est parcourue par un courant électrique, ledit deuxième sous-pixel comprenant également une troisième (C₂₁) et une quatrième (C₂₂) électrode agencées de part et d'autre de ladite deuxième couche active pour permettre à un courant électrique de la traverser sans traverser ladite première couche active ; et
- ladite troisième couche active (22, 6) dudit troisième sous pixel est agencée d'un deuxième coté de ladite première couche active, opposé audit premier coté, et adaptée pour émettre ladite lumière à ladite troisième longueur d'onde (λ₃) lorsqu'elle est excitée par la lumière à la première longueur d'onde émise par ladite première couche active dudit troisième sous-pixel, ledit troisième sous-pixel comprenant également une cinquième (C₃₁) et une sixième (C₃₂) électrode agencées de part et d'autre de ladite première couche active pour permettre à un courant électrique de la traverser.

2. Pixel selon la revendication 1 dans lequel ladite première longueur d'onde appartient à la partie bleue du spectre visible, ladite deuxième longueur d'onde à sa partie rouge et ladite troisième longueur d'onde à sa partie verte.

3. Pixel selon la revendication 1 dans lequel ladite première longueur d'onde appartient à la partie bleue du spectre visible, ladite deuxième longueur d'onde à sa partie verte et ladite troisième longueur d'onde à sa partie rouge.

4. Pixel selon l'une des revendications précédentes, présentant une structure monolithique.

5. Pixel selon la revendication 3 présentant une structure monolithique à l'exception de ladite troisième couche active (6), qui est rapportée.

6. Pixel selon l'une des revendications précédentes dans lequel lesdites couches actives sont réalisées à base de (Al,Ga,In)N.

7. Pixel selon l'une des revendications précédentes dans lequel lesdites premières couches actives desdits sous-pixels sont coplanaires, de même composition et de même structure.

8. Matrice de pixels comprenant une pluralité de pixels selon l'une des revendications précédentes hybridés sur un substrat hôte (7) portant un circuit de contrôle desdits sous-pixels, lesdites première et troisième couche active étant respectivement la couche active la plus proche et la plus éloignée dudit substrat hôte.

9. Structure semi-conductrice comprenant un empilement de couches épitaxiales semi-conductrices déposées sur un substrat (1), ledit empilement comprenant, à partir dudit substrat :
- un premier sous-ensemble de couches semi-conductrices (2) comprenant au moins une couche photoluminescente (22), dite troisième couche active, adaptée pour émettre une lumière à une longueur d'onde dite troisième longueur d'onde (λ₃), lesdites couches présentant un dopage d'un même type ;
- un deuxième sous-ensemble de couches semi-conductrices (3) formant une diode électroluminescente comprenant une couche électroluminescente (32), dite première couche active, adaptée pour émettre une lumière à une longueur d'onde dite première longueur d'onde (λ₁) ; et
- un troisième sous-ensemble de couches semi-conductrices (5) formant une diode électroluminescente comprenant une couche électroluminescente (52), dite deuxième couche active, adaptée pour émettre une lumière à une longueur d'onde dite deuxième longueur d'onde (λ₂) ;
lesdites première, deuxième et troisième longueur d'onde étant différentes entre elles et ladite première longueur d'onde étant inférieure auxdites deuxième et troisième longueurs d'onde.

10. Structure semi-conductrice selon la revendication 9 dans laquelle ledit premier sous-ensemble de couches semi-conductrices présente un dopage de type n et dans laquelle une jonction tunnel (4) est interposée entre ledit deuxième sous-ensemble et ledit troisième sous-ensemble de couches semi-conductrices.

11. Procédé de fabrication d'un pixel selon l'une des revendications 1 à 3 comportant les étapes suivantes :
a) procurer une structure semi-conductrice selon l'une des revendications 9 ou 10 ;
b) graver ladite structure pour définir un premier (P1), un deuxième (P2) et un troisième (P3) plots destinés à former des sous-pixels respectifs, au moyen d'une gravure s'étendant au moins à travers lesdites première et deuxième couches actives ;
c) graver ledit premier plot et ledit troisième plot, mais pas ledit deuxième plot, pour en retirer ladite deuxième couche active ;
d) réaliser une paire de contacts électriques (C₂₁, C₂₂) situés de part et d'autre de ladite deuxième couche active dudit deuxième plot, et deux paires de contacts électriques (C₁₁, C₁₂ ; C₃₁, C₃₂) situés de part et d'autre de ladite première couche active desdits premier et troisième plots ;
e) retirer ledit substrat ; et
f) graver la structure pour retirer ladite troisième couche active en correspondance desdits premier et deuxième plot, mais pas dudit troisième plot.

12. Procédé de fabrication d'un pixel selon la revendication 5 comportant les étapes suivantes :
a') procurer une structure semi-conductrice comprenant : un premier sous-ensemble de couches semi-conductrices (3') formant une diode électroluminescente comprenant une couche électroluminescente, dite première couche active (32), adaptée pour émettre une lumière à une longueur d'onde dite première longueur d'onde ; et un deuxième sous-ensemble de couches semi-conductrices (5') formant une diode électroluminescente comprenant une couche électroluminescente, dite deuxième couche active (52'), adaptée pour émettre une lumière à une longueur d'onde dite deuxième longueur d'onde, supérieure à ladite première longueur d'onde ;
b) graver ladite structure pour définir un premier (P1'), un deuxième (P2') et un troisième (P3') plots destinés à former des sous-pixels respectifs, au moyen d'une gravure s'étendant à travers lesdites première et deuxième couches actives ;
c) graver ledit premier plot et ledit troisième plot, mais pas ledit deuxième plot, pour en retirer ladite deuxième couche active ;
d) réaliser une paire de contacts électriques (C₂₁, C₂₂) situés de part et d'autre de ladite deuxième couche active dudit deuxième plot, et deux paires de contacts électriques (C₁₁, C₁₂ ; C₃₁, C₃₂) situés de part et d'autre de ladite première couche active desdits premier et troisième plots ;
e) retirer ledit substrat ; et
f') soit rapporter, à la place dudit substrat, une couche photoluminescente dite troisième couche active adaptée pour émettre une lumière à une troisième longueur d'onde lorsqu'elle est excitée par une lumière à ladite première longueur d'onde, puis retirer par gravure ladite troisième couche active en correspondance dudit premier et deuxième plots ; soit rapporter ladite troisième couche active en correspondance dudit troisième plot et à l'exclusion dudit premier et deuxième plots.

## Patentansprüche

1. Pixel, das wenigstens drei Seite an Seite angeordnete Subpixel (P1, P2, P3; P1', P2', P3'; P1", P2", P3") umfasst, wobei jedes Subpixel einen jeweiligen Stapel von Halbleiterschichten umfasst, in dem:
- jedes Subpixel eine erste aktive Schicht (32, 360) umfasst, ausgelegt zum Aussenden von Licht mit einer ersten Wellenlänge (λ₁), wenn es von einem elektrischen Strom durchflossen wird;
- wenigstens ein Subpixel, erstes Subpixel (P1, P1', P1") genannt, auch eine erste (C₁₁) und eine zweite (C₁₂) Elektrode umfasst, die auf beiden Seiten der ersten aktiven Schicht angeordnet sind, so dass sie von einem elektrischen Strom durchflossen werden kann;
- ein anderes der Subpixel, zweites Subpixel (P2, P2', P2") genannt, auch eine zweite aktive Schicht (52, 52') umfasst, ausgelegt zum Aussenden von Licht mit einer zweiten Wellenlänge (λ₂), die größer ist als die erste Wellenlänge;
- ein anderes der Subpixel, drittes Subpixel (P3, P3', P3") genannt, auch eine dritte aktive Schicht (22, 6, 320) umfasst, ausgelegt zum Aussenden von Licht mit einer dritten Wellenlänge (λ₃), die größer ist als die erste Wellenlänge und sich von der zweiten Wellenlänge unterscheidet;
wobei mindesten eine der zweiten und dritten aktiven Schicht zum Aussenden des Lichts ausgelegt ist, wenn sie von dem Licht mit der ersten Wellenlänge angeregt wird, das von der ersten aktiven Schicht desselben Subpixels ausgesendet wird,
wobei das Pixel **dadurch gekennzeichnet ist, dass**:
- die erste aktive Schicht (32) wenigstens teilweise für die zweite Wellenlänge (λ₂) durchlässig ist;
- die zweite aktive Schicht (52, 52') des zweiten Subpixels auf einer ersten Seite der ersten aktiven Schicht angeordnet und zum Aussenden des Lichts mit der zweiten Wellenlänge (λ₂) ausgelegt ist, wenn sie von einem elektrischen Strom durchflossen wird, wobei das zweite Subpixel auch eine dritte (C₂₁) und eine vierte (C₂₂) Elektrode umfasst, die auf beiden Seiten der zweiten aktiven Schicht angeordnet sind, so dass ein elektrischer Strom durch sie fließen kann, ohne durch die erste aktive Schicht zu fließen; und
- die dritte aktive Schicht (22, 6) des dritten Subpixels auf einer zweiten Seite der ersten aktiven Schicht gegenüber der ersten Seite angeordnet und zum Aussenden des Lichts mit der dritten Wellenlänge (λ₃) ausgelegt ist, wenn sie von dem Licht mit der ersten Wellenlänge angeregt wird, das von der ersten aktiven Schicht des dritten Subpixels ausgesendet wird, wobei das dritte Subpixel auch eine fünfte (C₃₁) und eine sechste (C₃₂) Elektrode umfasst, die auf beiden Seiten der ersten aktiven Schicht angeordnet ist, so dass sie von einem elektrischen Strom durchflossen werden kann.

2. Pixel nach Anspruch 1, bei dem die erste Wellenlänge zum blauen Teil, die zweite Wellenlänge zum roten Teil und die dritte Wellenlänge zum grünen Teil des sichtbaren Spektrums gehört.

3. Pixel nach Anspruch 1, bei dem die erste Wellenlänge zum blauen Teil, die zweite Wellenlänge zum grünen Teil und die dritte Wellenlänge zum roten Teil des sichtbaren Spektrums gehört.

4. Pixel nach einem der vorherigen Ansprüche, das eine monolithische Struktur aufweist.

5. Pixel nach Anspruch 3, das eine monolithische Struktur mit Ausnahme der dritten aktiven Schicht (6) aufweist, die angesetzt ist.

6. Pixel nach einem der vorherigen Ansprüche, in dem die aktiven Schichten auf der Basis von (Al,Ga,In)N realisiert sind.

7. Pixel nach einem der vorherigen Ansprüche, bei dem die ersten aktiven Schichten der Subpixel koplanar sind, mit derselben Zusammensetzung und derselben Struktur.

8. Pixelmatrix, die mehrere Pixel nach einem der vorherigen Ansprüche umfasst, hybridisiert auf einem Wirtssubstrat (7), das eine Schaltung zum Steuern der Subpixel trägt, wobei die erste und die dritte aktive Schicht die dem Wirtssubstrat am nächsten liegende aktive Schicht bzw. die davon am weitesten entfernte aktive Schicht sind.

9. Halbleiterstruktur, die einen Stapel von epitaxialen Halbleiterschichten umfasst, die auf einem Substrat (1) angeordnet sind, wobei der Stapel vom Substrat aus betrachtet Folgendes umfasst:
- einen ersten Teilsatz von Halbleiterschichten (2), der wenigstens eine fotolumineszente Schicht (22) umfasst, dritte aktive Schicht genannt, ausgelegt zum Aussenden von Licht mit einer Wellenlänge, dritte Wellenlänge (λ₃) genannt, wobei die Schichten eine Dotierung eines selben Typs aufweisen;
- einen zweiten Teilsatz von Halbleiterschichten (3), der eine Leuchtdiode bildet, die eine elektrolumineszente Schicht (32) umfasst, erste aktive Schicht genannt, ausgelegt zum Aussenden von Licht mit einer Wellenlänge, erste Wellenlänge (λ₁) genannt; und
- einen dritten Teilsatz von Halbleiterschichten (5), der eine Leuchtdiode bildet, die eine elektrolumineszente Schicht (52) umfasst, zweite aktive Schicht genannt, ausgelegt zum Aussenden von Licht mit einer Wellenlänge, zweite Wellenlänge (λ₂) genannt;
wobei sich die erste, zweite und dritte Wellenlänge voneinander unterscheiden und wobei die erste Wellenlänge kleiner ist als die zweite und die dritte Wellenlänge.

10. Halbleiterstruktur nach Anspruch 9, bei der der erste Teilsatz von Halbleiterschichten eine Dotierung des n-Typs aufweist und bei der sich eine Tunnelverbindung (4) zwischen dem zweiten Teilsatz und dem dritten Teilsatz von Halbleiterschichten befindet.

11. Verfahren zur Herstellung eines Pixels nach einem der Ansprüche 1 bis 3, das die folgenden Schritte beinhaltet:
a) Beschaffen einer Halbleiterstruktur nach Anspruch 9 oder 10;
b) Ätzen der Struktur zum Definieren einer ersten (P1), einer zweiten (P2) und einer dritten (P3) Kontaktstelle, bestimmt zum Bilden von jeweiligen Subpixeln, mittels einer Ätzung, die wenigstens durch die erste und zweite aktive Schicht verläuft;
c) Ätzen der ersten Kontaktstelle und der dritten Kontaktstelle, aber nicht der zweiten Kontaktstelle, um die zweite aktive Schicht davon zu entfernen;
d) Realisieren eines Paares von elektrischen Kontakten (C₂₁, C₂₂), die sich auf beiden Seiten der zweiten aktiven Schicht der zweiten Kontaktstelle befinden, und von zwei Paaren von elektrischen Kontakten (C₁₁, C₁₂; C₃₁, C₃₂), die sich auf beiden Seiten der ersten aktiven Schicht der ersten und dritten Kontaktstelle befinden;
e) Entfernen des Substrats; und
f) Ätzen der Struktur, um die dritte aktive Schicht entsprechend der ersten und zweiten Kontaktstelle, aber nicht der dritten Kontaktstelle zu entfernen.

12. Verfahren zur Herstellung eines Pixels nach Anspruch 5, das die folgenden Schritte beinhaltet:
a') Beschaffen einer Halbleiterstruktur, die Folgendes umfasst: einen ersten Teilsatz von Halbleiterschichten (3'), die eine Leuchtdiode bilden, die eine elektrolumineszente Schicht umfasst, erste aktive Schicht (32) genannt, ausgelegt zum Aussenden von Licht mit einer Wellenlänge, erste Wellenlänge genannt; und einen zweiten Teilsatz von Halbleiterschichten (5'), die eine Leuchtdiode bilden, die eine elektrolumineszente Schicht umfasst, zweite aktive Schicht (52') genannt, ausgelegt zum Aussenden von Licht mit einer Wellenlänge, zweite Wellenlänge genannt, die größer ist als die erste Wellenlänge;
b) Ätzen der Struktur zum Definieren einer ersten (P1'), zweiten (P2') und dritten (P3') Kontaktstelle, bestimmt zum Bilden von jeweiligen Subpixeln mittels einer Ätzung, die durch die erste und die zweite aktive Schicht verläuft;
c) Ätzen der ersten Kontaktstelle und der dritten Kontaktstelle, aber nicht der zweiten Kontaktstelle, um die zweite aktive Schicht davon zu entfernen;
d) Realisieren eines Paares von elektrischen Kontakten (C₂₁, C₂₂), die sich auf beiden Seiten der zweiten aktiven Schicht der zweiten Kontaktstelle befinden, und von zwei Paaren von elektrischen Kontakten (C₁₁, C₁₂; C₃₁, C₃₂), die sich auf beiden Seiten der ersten aktiven Schicht der ersten und dritten Kontaktstelle befinden;
e) Entfernen des Substrats; und
f') entweder Ansetzen, anstelle des Substrats, einer fotolumineszenten Schicht, dritte aktive Schicht genannt, ausgelegt zum Aussenden von Licht mit einer dritten Wellenlänge, wenn sie von Licht mit der ersten Wellenlänge angeregt wird, dann Entfernen, durch Ätzen, der dritten aktiven Schicht entsprechend der ersten und zweiten Kontaktstelle; oder Ansetzen der dritten aktiven Schicht entsprechend der dritten Kontaktstelle und unter Ausschluss der ersten und zweiten Kontaktstelle.

## Claims

1. A pixel comprising at least three sub-pixels (P1, P2, P3; P1', P2', P3'; P1", P2", P3") disposed one alongside the other, each said sub-pixel comprising a respective stack of semi-conducting layers, in which:
- each said sub-pixel comprises a first active layer (32, 360), adapted for emitting a light at a first wavelength (λ₁) when an electric current passes through it;
- at least one said sub-pixel, termed the first sub-pixel (P1, P1', P1"), also comprises a first (C₁₁) and a second (C₁₂) electrode arranged on either side of said first active layer so as to allow an electric current to pass through it;
- another of said sub-pixels, termed the second sub-pixel (P2, P2', P2"), also comprises a second active layer (52, 52'), adapted for emitting a light at a second wavelength (λ₂) greater than said first wavelength;
- another of said sub-pixels, termed the third sub-pixel (P3, P3', P3"), also comprises a third active layer (22, 6, 320), adapted for emitting a light at a third wavelength (λ₃) greater than said first wavelength and different from said second wavelength;
at least one from among said second and third active layers being adapted for emitting said light when it is excited by the light at the first wavelength emitted by said first active layer of the same sub-pixel
said pixel being **characterized in that**:
- said first active layer (32) is at least partially transparent to said second wavelength (λ₂);
- said second active layer (52, 52') of said second sub-pixel is arranged on a first side of said first active layer and adapted for emitting said light at said second wavelength (λ₂) when it is traversed by an electric current, said second sub-pixel also comprising a third (C₂₁) and a fourth (C₂₂) electrode arranged on either side of said second active layer so as to allow an electric current to pass through it without passing through said first active layer; and
- said third active layer (22, 6) of said third sub-pixel is arranged on a second side of said first active layer, opposite to said first side, and adapted for emitting said light at said third wavelength (λ₃) when it is excited by the light at the first wavelength emitted by said first active layer of said third sub-pixel, said third sub-pixel also comprising a fifth (C₃₁) and a sixth (C₃₂) electrode arranged on either side of said first active layer so as to allow an electric current to pass through it.

2. The pixel as claimed in claim 1, in which said first wavelength belongs to the blue part of the visible spectrum, said second wavelength to its red part and said third wavelength to its green part.

3. The pixel as claimed in claim 1, in which said first wavelength belongs to the blue part of the visible spectrum, said second wavelength to its green part and said third wavelength to its red part.

4. The pixel as claimed in one of the preceding claims, exhibiting a monolithic structure.

5. The pixel as claimed in claim 3, exhibiting a monolithic structure with the exception of said third active layer (6), which is added.

6. The pixel as claimed in one of the preceding claims, in which said active layers are produced based on (Al,Ga,In)N.

7. The pixel as claimed in one of the preceding claims, in which said first active layers of said sub-pixels are coplanar, of the same composition and of the same structure.

8. A matrix of pixels comprising a plurality of pixels according to one of the preceding claims, hybridized on a host substrate (7) carrying a control circuit for said sub-pixels, said first and third active layers being respectively the active layer closest to and furthest from said host substrate.

9. A semi-conducting structure comprising a stack of semi-conducting epitaxial layers deposited on a substrate (1), said stack comprising, starting from said substrate:
- a first subset of semi-conducting layers (2) comprising at least one photoluminescent layer (22), termed the third active layer, adapted for emitting a light at a wavelength termed the third wavelength (λ₃), said layers exhibiting a doping of one and the same type;
- a second subset of semi-conducting layers (3) forming a light-emitting diode comprising an electroluminescent layer (32), termed the first active layer, adapted for emitting a light at a wavelength termed the first wavelength (λ₁); and
- a third subset of semi-conducting layers (5) forming a light-emitting diode comprising an electroluminescent layer (52), termed the second active layer, adapted for emitting a light at a wavelength termed the second wavelength (λ₂);
said first, second and third wavelengths being mutually different and said first wavelength being less than said second and third wavelengths.

10. The semi-conducting structure as claimed in claim 9, in which said first subset of semi-conducting layers exhibits a doping of type n and in which a tunnel junction (4) is interposed between said second subset and said third subset of semi-conducting layers.

11. A method for fabricating a pixel as claimed in one of claims 1 to 3, comprising the following steps:
a) procuring a semi-conducting structure as claimed in one of claims 9 or 10;
b) etching said structure to define a first (P1), a second (P2) and a third (P3) pads intended to form respective sub-pixels, by means of an etching extending at least through said first and second active layers;
c) etching said first pad and said third pad, but not said second pad, so as to remove said second active layer therefrom;
d) producing a pair of electrical contacts (C₂₁, C₂₂) situated on either side of said second active layer of said second pad, and two pairs of electrical contacts (C₁₁, C₁₂; C₃₁, C₃₂) situated on either side of said first active layer of said first and third pads;
e) removing said substrate; and
f) etching the structure so as to remove said third active layer in correspondence with said first and second pads, but not with said third pad.

12. A method for fabricating a pixel as claimed in claim 5, comprising the following steps:
a') procuring a semi-conducting structure comprising: a first subset of semi-conducting layers (3') forming a light-emitting diode comprising an electroluminescent layer, termed the first active layer (32), adapted for emitting a light at a wavelength termed the first wavelength; and a second subset of semi-conducting layers (5') forming a light-emitting diode comprising an electroluminescent layer, termed the second active layer (52'), adapted for emitting a light at a wavelength termed the second wavelength, greater than said first wavelength;
b) etching said structure to define a first (P1'), a second (P2') and a third (P3') pads intended to form respective sub-pixels, by means of an etching extending through said first and second active layers;
c) etching said first pad and said third pad, but not said second pad, so as to remove said second active layer therefrom;
d) producing a pair of electrical contacts (C₂₁, C₂₂) situated on either side of said second active layer of said second pad, and two pairs of electrical contacts (C₁₁, C₁₂; C₃₁, C₃₂) situated on either side of said first active layer of said first and third pads;
e) removing said substrate; and
f) either adding, in place of said substrate, a photoluminescent layer termed the third active layer adapted for emitting a light at a third wavelength when it is excited by a light at said first wavelength, and then removing by etching said third active layer in correspondence with said first and second pads; or adding said third active layer in correspondence with said third pad and with the exclusion of said first and second pads.
